# EUROPEAN PATENT APPLICATION

(11) **EP 4 628 908 A1**
(43) Date of publication of application: **08.10.2025**
(21) Application number: 24168521.3
(22) Date of filing: 04.04.2024
(51) Int. Cl.: G01R 31/12, G01R 31/14

(54) **DEVICE FOR SYNCHRONIZING A PARTIAL DISCHARGE MONITORING SYSTEM**

(71) Applicant: GE Vernova Technology GmbH, 5400 Baden (CH)
(72) Inventor: JUGE, Patrice, 73100 Aix-les-Bains (FR); LEBRETON, Raphaël, 73100 Aix-les-Bains (FR)
(74) Representative: Rüger Abel Patentanwälte PartGmbB

(57) **Abstract**

The invention concerns a device (100) for providing a synchronisation signal to identify partial discharges in a GIS comprising:
- an AC reference switch device (20), comprising a plurality of inputs for inputtinga plurality of synchronisation signalsfrom a plurality of sensors, said switch device comprising means for selecting an input among said plurality of inputs based on the presence of a synchronisation signals ;
- an AC inverter (30) to provide a power and synchronisation signal, based on said synchronisation signal provided by said AC reference switch device (20).

## Description

### TECHNICAL FIELD AND PRIOR ART

The invention concerns the synchronisation of detections of partial discharges in a high voltage equipment such as Gas Insulated Station (GIS).

GIS damages can be caused by partial discharges which may result from a variety of origins, for example from protrusions and/or the presence of particles and/or any kind of inhomogeneity on or in an internal surface of a GIS.

Such partial discharges can be detected by a variety of devices, for example by optical or acoustical or Ultra-High Frequencies (UHF) devices.

All these detections requires a synchronisation with the high voltage (usually 50 Hz or 60 Hz) to allow the identification of the nature of the defect. However such a synchronisation is not always available.

There is a technical problem to be solved which is related to the improvement of the synchronisation of the detection of partial discharges, included by UHF based methods. In particular, there is the problem of finding a method and device providing a synchronisation allowing an identification of any partial discharge in a GIS.

Furthermore, a synchronisation system for the detection of partial discharges is complicated: for example a UHF partial discharge detector requires a power signal and an acquisition signal. Generating both signals is complicated and multiplies the number of connections.

There is thus another technical problem to be solved which is related to finding a simplified system and method for the synchronisation of the detection of partial discharges by UHF based methods.

Another problem is that the primary voltage source - on which any synchronisation is based - can be measured at multiple locations. The sensors used for this have characteristics that may be different and not compatible with long signal links.

There is thus another technical problem to be solved which is related to finding a simplified system and method allowing a synchronisation based on detections at multiple locations.

In this invention, a new device is proposed for managing these multiple voltage sources and distributing them to the Partial Discharge monitoring system, safely.

### SUMMARY OF THE INVENTION

In order to solve one or more of the above problems, the inventors have found a new device and method for generating and providing a synchronisation signal to identify partial discharges in a GIS.

The invention first concerns a device for providing a synchronisation signal to identify partial discharges in a GIS comprising:
- an AC reference switch device, comprising a plurality of inputs for inputting a plurality of synchronisation signals from one or more measuring device(s), for example HV voltage transformer(s), said switch device comprising means for selecting an input among said plurality of inputs based on the presence of a synchronisation signals;
- an AC inverter to provide a power and synchronisation signal, based at least on said synchronisation signal provided by said AC reference switch device.

Said AC inverter may comprise at least one of a transformer, and/or a microcontroller and/or phase compensation means.

In a device according to the invention, said AC reference switch device can comprise a test signal input. A priority rule can be established in said AC reference switch device so that a test signal has priority over other signals from one or more measuring device(s).

Said AC reference switch device can comprise a power supply.

Said AC inverter can comprise a power supply, said AC inverter providing a power and synchronisation signal, based on said synchronisation signal provided by said AC reference switch device and on said power supply.

The invention also concerns a device for identifying partial discharges in a GIS comprising:
- a device for providing a synchronisation signal according to the invention;
- a plurality of partial discharges acquisition units, each one comprising a power input and a synchronisation input both connected to the output of said AC inverter and one or more signal input(s) to receive one or more signal(s) from one or more partial discharge sensor(s).

One or more of said partial discharges acquisition units may be connected to one or more partial discharge sensor(s). Said one or more of said partial discharge sensor(s) can for example comprise one or more optical and/or acoustic and/or UHF sensor(s).

The invention also concerns a GIS comprising:
- a metal tank filled with a gas and comprising at least one primary conductor;
- one or more sensor(s) to detect partial discharges;
- at least one measuring device to detect a HV signal in said primary conductor;
- a system according to the invention, each measuring device being connected to an input of the AC reference switch device, and each sensor being connected to an input of a partial discharge acquisition unit.

One or more sensor(s) can comprise one or more optical and/or acoustic and/or UHF sensor(s) and/or one or more measuring device can comprise one or more HV voltage transformers.

The invention also concerns a method for detecting partial discharges in a GIS according to the invention, whereby:
- one or more measuring device(s) provide(s) one or more input(s) of the plurality of inputs of the AC reference switch device with synchronisation signal(s),
- said AC inverter provides a power and synchronisation signal to each of a plurality of partial discharges acquisition units;
- said partial discharges acquisition units synchronises partial discharge signal(s) with said synchronisation signal.

A test signal can be supplied to an input of the AC reference switch device. Said test signal is for example selected by said AC reference switch device during a test phase of the GIS.

### BRIEF DESCRIPTION OF THE DRAWINGS

- figure 1 shows an example a single line diagram of a high voltage installation to which the invention can be applied;
- figure 2 shows an example of a switch device according to the invention;
- figure 3A shows an embodiment of an AC inverter according to the invention;
- figure 3B shows an embodiment of a signal provided by an AC inverter according to the invention;
- figure 4 shows an example of a device according to the invention for providing a synchronisation signal to identify partial discharges;
- figure 5 shows an example of a partial discharge acquisition unit according to the invention.

### DETAILLED DESCRIPTION OF SPECIFIC EMBODIMENTS

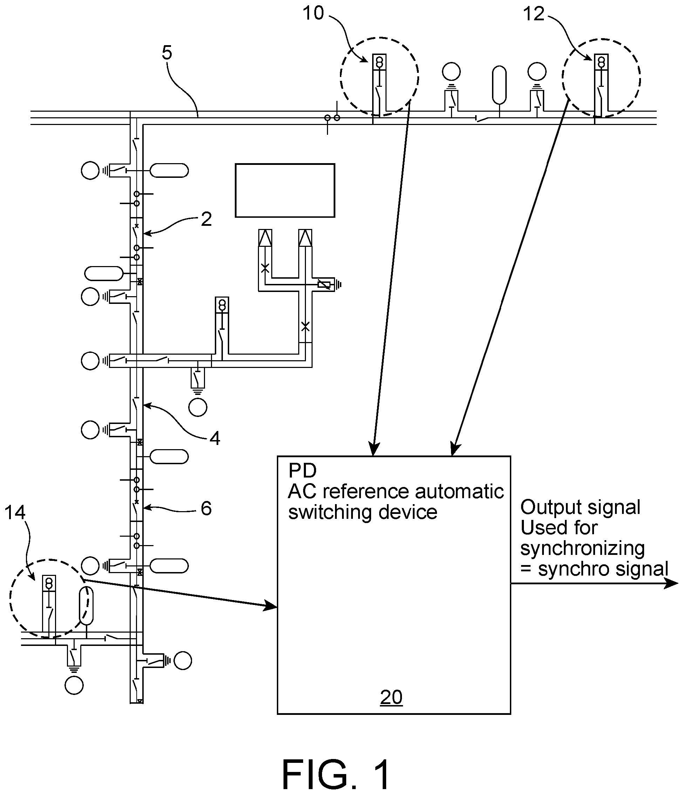

An example of a high voltage installation 2 to which the invention can be applied is illustrated on figure 1

It comprises a HV line, comprising at least one primary conductor 5 and can be provided with a plurality of circuit breakers 2,4, 6 ....

It is also provided with a plurality of measuring devices 10, 12, 14, for example voltage transformers, which measure the HV signal (for example at a frequency of 50 Hz) at a plurality of measuring points and reduce of the detected voltage to a value of for example less than 100 V.

It is also provided with a plurality of partial discharge (PD) sensors (not shown on the drawings) such as optical and/or acoustic and/or UHF sensor(s) to detect the presence of partial discharges based on other methods, for example optical or acoustic or UHF methods.

Partial discharges generate frequencies in a range of for example 100 MHz - 2 GHz.

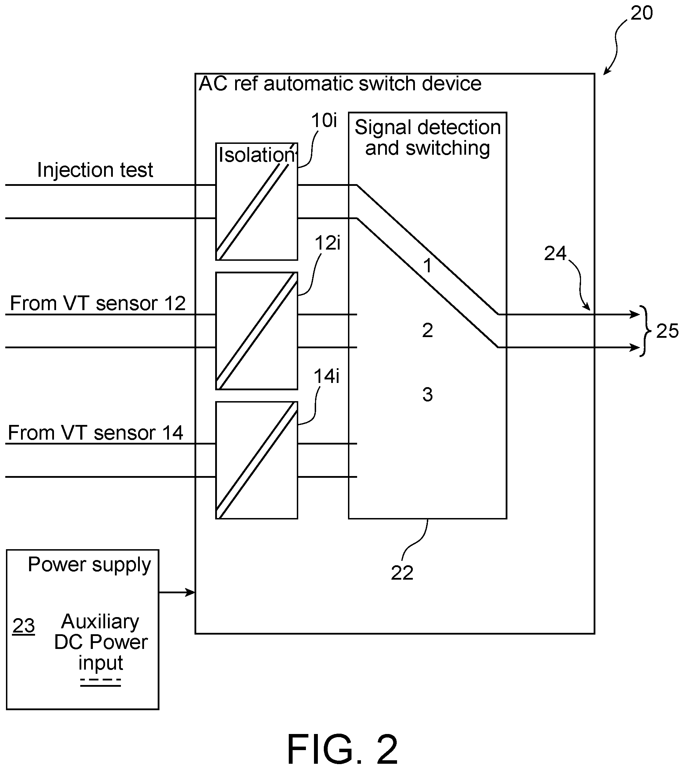

The outputs of the various measuring devices 10, 12, 14 are provided to a switch device 20, an embodiment of which is illustrated on figure 2. It comprises a plurality of voltage inputs 10ᵢ, 12ᵢ, 14ᵢ, each one being for receiving an input from one of the measuring devices 10, 12, 14. These inputs are compatible with a plurality of sensors and sensor technologies.

An output 24 of said switch device 20 provides a synchronisation signal 25.

Switch device 20 comprises signal detection and switching means 22 to select one of the inputs on which a synchronisation signal is indeed detected: any of the measuring devices 10, 12, 14 may be at any time disconnected from the HV signal by a circuit-breaker located between the HV line and the measuring device.

The partial detection system therefore cannot rely on a particular measuring devices to receive a synchronisation signal : for this reason, means 22 are checking whether a signal is indeed provided to the input to which the output 24 is connected through the switch device 20; in the absence of voltage on the first input, it switches to the next one; more generally, in the absence of voltage on one (n) of the inputs, it switches to another input, for example the next one (n+1) or to the first one if there is no next one.

The several inputs 10ᵢ, 12ᵢ, 14ᵢ are electrically separated from each other make it possible to acquire in all the configurations of the primary equipment at least one synchronization signal.

The first input channel 10ᵢ can be a test signal injection input which has priority over the others

The test signal is provided to the system during a test phase: it can have a different frequency than that of the network, depending on the available test signal generator. It can be incompatible - in particular because of its intensity - with the measuring devices 10, 12, 14 which may be switched off during the test. However, the PD sensors are still active and there is a need during the test phase for synchronizing their signals (resulting from partial discharge during the test) with the test signal. For this reason, the switch device comprises an input for this test signal, which preferably has priority over the other inputs. A device according to the invention thus allows synchronizing PD signals during a test phase.

The switch device 20 is also provided with an input voltage from a power supply 23.

The synchronisation signal provided by the switch device 20 is supplied to an AC inverter 30 which, based at least on the synchronisation signal 25, generates both a power and synchronisation signal at its output 34.

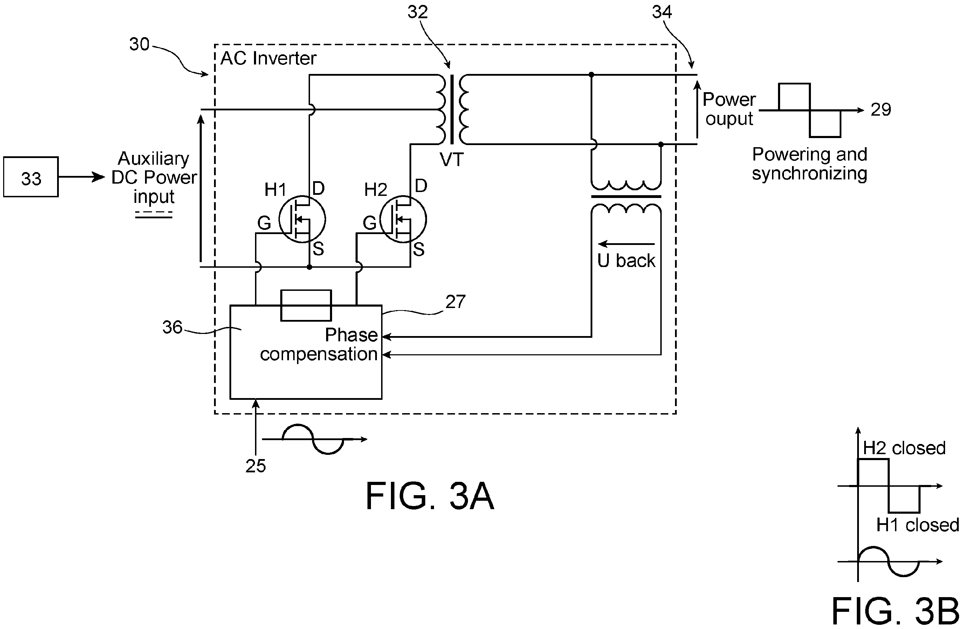

An embodiment of the AC inverter 30 is illustrated on figure 3A. It comprises a transformer 32 which is supplied by transistors H1, H2 connected downstream from a microcontroller 36 which is supplied by the synchronisation signal 25 but preferably also by a phase signal 27 as explained below.

The microcontroller 36 controls the transistors H1, H2 so that they are alternatively conducting. This generates a supply and synchronisation signal which is alternatively positive and negative at the input frequency of the synchronisation signal 25. A phase shift may result from transformer 32, which can be taken into account by the microcontroller 36 via a phase compensation input 27, so that the output signal is in phase with the input synchronisation signal 25.

An example of output signal of said AC inverter is illustrated on figure 3A but also on figure 3B.

The AC inverter 30 is also provided with an input voltage from a power supply 33. The inverter 30 generates an alternating power signal 29 based on this input voltage and the alternating signal input 25.

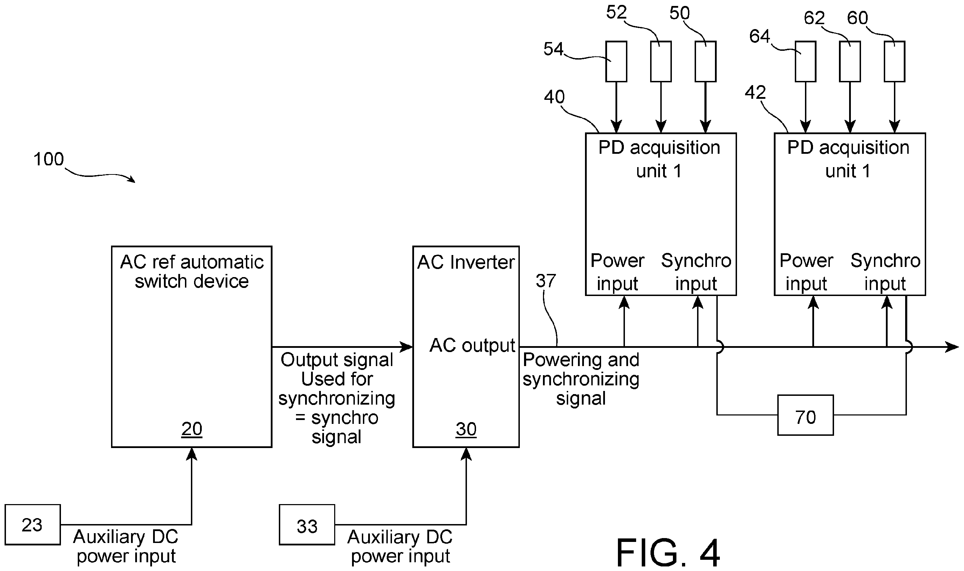

As shown on figure 4, each of a plurality of acquisition units 40, 42...is provided with the output signal 29 from the AC inverter 30 of a device 100 according to the invention for providing a synchronisation signal. The output signal 29 (comprising both the power and synchronisation signal) from the AC inverter 30 can be distributed via wirings 37 (preferably a single line) to the various acquisition units 40, 42 which can be distributed in a substation.

Each of the acquisition units 40, 42... can also be supplied with signals from one or more PD sensors, for example one or more UHF antennas, 50, 52, 54, 60, 62, 64, which detect partial discharges in the GIS of figure 1.

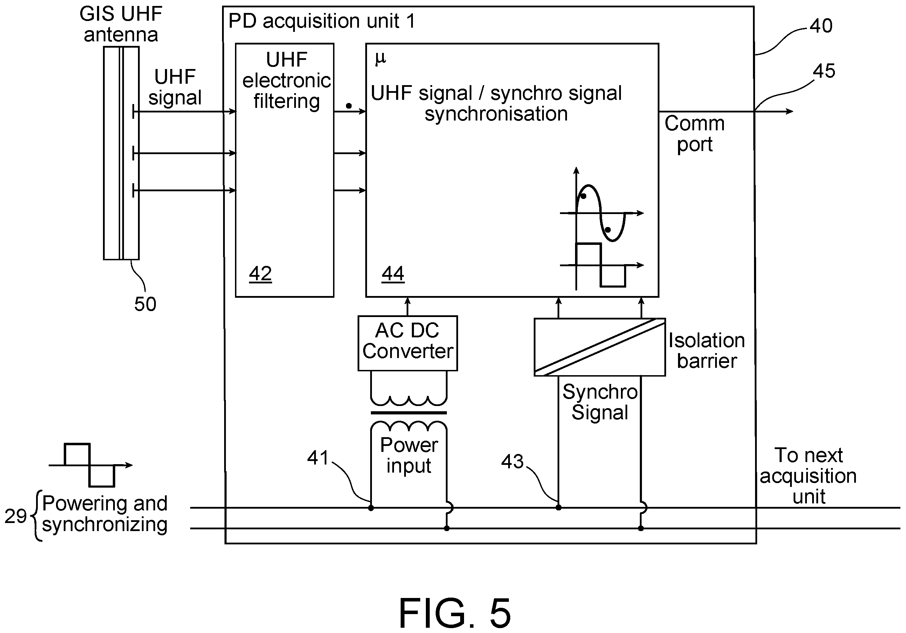

The outputs of each of the acquisition units 40, 42... can be supplied to a computer or a micro-processor 70 programmed to analyse the output signals from the acquisition units 40, 42...and classify the partial discharges according to their origins, for example from protrusions and/or the presence of particles and/or any kind of inhomogeneity on or in an internal surface of a GIS. An embodiment of an acquisition unit 40 is illustrated on figure 5. The other acquisition units 42... may have a same or similar architecture. Acquisition unit 40 is for connection to an antenna 50 (other antenna, and/or other PD sensor(s), also being possibly connected to said unit 40) and comprises a filtering stage 42 and a synchronisation stage 44 able to synchronise a UHF signal from any antenna 50, 52, 54 with the synchronisation signal 29 provided by the AC inverter 30; in other words, each acquisition units internally time-synchronize signals.

The synchronisation stage 44 may comprise several inputs for the PD sensors, input(s) for the synchronisation and power signal, and an output. The signal from the PD sensors are time synchronized with a synchronisation input. The output 45 (see figures 4 and 5), 47 (figure 5) is for example for connection to an Ethernet network or to an analog network or device or any to other digital or analog device or network, for example through copper wires or optical devices or fibers; alternatively synchronisation stage 40 can comprise means for a wireless communication. The outputs of each of the acquisition units 40, 42... can be supplied to computer or micro-processor 70 through any of these communication means

The acquisition unit 40 is also provided with the signal generated by the AC inverter as a power input signal. In other words, the same signal 29 output by the AC inverter 30 is supplied to each acquisition unit 40, 42,... both as a power signal and as a synchronisation signal, thereby achieving a simplification of the system and avoiding a multiplication of connections.

The invention has the capacity to comply with many configurations of HV substation SLD single Line Diagram scheme and HV apparatus positions.

In a device according to the invention:
- both stages 20 and 30, and in particular the transformer 32, form an electric insulation between the measuring devices, in particular when they comprise voltage transformers 10, 12, 14, and the downstream side of the system, namely beyond stages 20, 30 and the acquisition units 40, 42; in particular, voltage transformers 10, 12, 14 are particularly sensitive to short-circuits, which could for example happen on line 37, and should be kept insulated from said downstream side;
- the destructive risks for the HV measuring devices associated with a complicated connection network of cables are eliminated: they are all connected to switch device 20 and there is no need to connect each of them with said connection network to the different acquisition units 40, 42; such connection network entails a risk of short circuits, which can in particular be dangerous for the voltage transformers 10, 12, 14 ;
- the time lags between the primary signal and the secondary signal are negligible, thanks to the phase compensation input 27;
- the secondary signal (between AC inverter 30 and acquisition units 40, 42) can be transported over long distances thanks to the power supply;
- the main output of the AC inverter 30 which is dedicated to synchronization benefits from an additional power provided by the power source 33 of the device, both being combined in the module 44 of each acquisition unit 40;
- the main output voltage of the AC inverter is accurate in phase with the input signal.

The invention is compatible with many different configurations of HV substation SLD single line diagram scheme and HV apparatus positions.

The time lags between the primary signal (input of switch 20) and the secondary signal (output of AC converter 30) are negligible.

After default signals are recorded with a device according to the invention, they can be compared to typical signatures recorded in the database. Once the type of the signal has been recognized, it becomes possible to dismantle the primary equipment at a specific location, in order to take the necessary maintenance actions.

The AC reference switch device 20 and the AC inverter 30 were described as two separate devices, but alternatively can be combined in a same device.

## Claims

1. A device (100) for providing a synchronisation signal (25) to identify partial discharges in a GIS comprising:
- an AC reference switch device (20), comprising a plurality of inputs for inputting a plurality of synchronisation signals (10ᵢ, 12ᵢ, 14ᵢ) from at least one measuring device, said switch device comprising means (22) for selecting an input among said plurality of inputs based on the presence of a synchronisation signals ;
- an AC inverter (30) to provide a power and synchronisation signal (29), based at least on said synchronisation signal provided by said AC reference switch device (20).

2. A device according to claim 1, said AC inverter comprising a transformer (32).

3. A device according to claim 1 or 2, said AC inverter comprising a microcontroller (36).

4. A device according to any of claims 1 to 3, said AC inverter comprising phase compensation means (36).

5. A device according to any of claims 1 to 4, said AC reference switch device (20), comprising a test signal input (10ᵢ).

6. A device according to any of claims 1 to 5, comprising a power supply (23) of said AC reference switch device (20).

7. A device according to any of claims 1 to 6, comprising a power supply (33) of said AC inverter (30), said AC inverter (30) providing a power and synchronisation signal, based on said synchronisation signal provided by said AC reference switch device (20) and on said power supply (33).

8. A system for identifying partial discharges in a GIS comprising:
- a device for providing a synchronisation signal according to any of claims 1 to 7;
- a plurality of partial discharges acquisition units (40, 42), each one comprising a power input (41) and a synchronisation input (43) both connected to the output of said AC inverter (30) and one or more signal input(s) to receive one or more signal(s) from one or more partial discharge sensor(s).

9. A system (100) according to claim 8, one or more of said partial discharges acquisition units being connected to a one or more partial discharge sensor(s) (50-54, 60-64).

10. A system (100) according to claim 9, said one or more of said partial discharge sensor(s) (50-54, 60-64) comprising one or more optical and/or acoustic and/or UHF sensor(s).

11. A GIS comprising:
- a metal tank (1) filled with a gas and comprising at least one primary conductor (5);
- a plurality of sensors to detect partial discharges;
- at least one measuring device (10, 12, 14) to detect a HV signal in said primary conductor (5);- a system according to any of claims 9 or 10, each measuring device being connected to an input of the AC reference switch device (20), and each sensor being connected to an input of a partial discharge acquisition unit (40, 42).

12. A GIS according to claim 11:
- one or more sensor(s) comprising one or more optical and/or acoustic and/or UHF sensor(s);
- and/or one or more measuring device (10, 12, 14) comprising one or more voltage transformers.

13. A method for detecting partial discharges in a GIS according to any of claims 11 to 12, whereby:
- each of a plurality of measuring device (10, 12, 14) provides one input of the plurality of inputs of the AC reference switch device with synchronisation signals,
- said AC inverter (30) provides a power and synchronisation signal (29) to each of a plurality of partial discharges acquisition units;
- said partial discharges acquisition units synchronises partial discharge signal(s) with said synchronisation signal (29).

14. A method according to claim 13, a test signal being supplied to an input of the AC reference switch device (20).

15. A method according to claim 14, said test signal being selected by said AC reference switch device (20) during a test phase of the GIS.
